# EUROPÄISCHE PATENTSCHRIFT

(11) **EP 2 126 995 B1**
(45) Veröffentlichungstag und Bekanntmachung des Hinweises auf die Patenterteilung: **04.01.2012**
(21) Anmeldenummer: 08707901.8
(22) Anmeldetag: 15.01.2008
(51) Int. Cl.: H01L 41/24, H01L 41/22

(54) **Verfahren zur Herstellung eines piezokeramischen Vielschichtaktors**
Method for the production of a piezoceramic multilayer actuator
Procédé de fabrication d'un actionneur multicouche piézocéramique

(30) Priorität: 31.01.2007 DE 102007004813
(43) Veröffentlichungstag der Anmeldung: 02.12.2009
(73) Patentinhaber: Siemens Aktiengesellschaft, 80333 München (DE)
(72) Erfinder: LENK, Andreas, 01728 Bannewitz Ot Possendorf (DE); SCHUH, Carsten, 85598 Baldham (DE); GANSTER, Axel, 84419 Schwindegg (DE); KORNELY, Susanne, 80689 München (DE); MANTOVAN, Andreas, 93128 Regenstauf (DE); ZAPF, Jörg, 81927 München (DE)
(86) Internationale Anmeldenummer: PCT/EP2008/050403
(87) Internationale Veröffentlichungsnummer: WO 2008/092740

(56) Entgegenhaltungen:
- DE-A1- 4 410 504
- DE-A1- 10 021 919
- DE-A1-102004 012 033
- DE-A1-102005 008 363
- JP-A- 1 184 968
- JP-A- 5 267 743
- US-A- 5 191 688
- US-A- 5 252 883
- US-A- 5 254 212

## Beschreibung

Die vorliegende Erfindung betrifft ein Verfahren zur Herstellung eines piezokeramischen Vielschichtaktors.

Basierend auf dem piezoelektrischen Effekt können sich piezoelektrische Keramiken geeigneter Kristallstruktur bei Erzeugen eines elektrischen Feldes in ihrem Inneren ausdehnen oder zusammen ziehen. Diese Längenänderung findet nahezu ohne Verzögerung bezogen auf das steuernde elektrische Signal statt und ist zudem genau regelbar. Daher werden piezoelektrische Vielschichtaktoren als Stellelemente eingesetzt.

Da die steuernde elektrische Feldstärke in solchen Vielschichtaktoren im Bereich von mehreren kV/mm liegt, aber moderate Ansteuer-Spannungen beim Einsatz der Vielschichtaktoren in der Praxis gewünscht sind, werden die piezokeramischen Vielschichtaktoren mit Schichtdicken im Bereich von 100 µm hergestellt. Typische Herstellungsverfahren sind das Schlickergießen oder Trockenpressen. Die einzelnen keramischen Schichten werden metallisiert und übereinander gestapelt, so dass zwischen zwei keramischen Schichten Innenelektroden entgegengesetzter Polarität den Piezoeffekt erzeugen können. Über eine Außenmetallisierung parallel zur Stapelrichtung bzw. Längsachse des piezokeramischen Vielschichtaktors werden wechselseitig alle Innenelektroden desselben elektrischen Potentials elektrisch angesteuert. Damit die Innenelektroden des jeweils entgegengesetzten elektrischen Potentials nicht kurzgeschlossen werden, sind diese im Bereich der Außenmetallisierung der Innenelektroden des jeweils entgegengesetzten Potentials versetzt in Bezug auf die anderen Elektroden angeordnet. Durch diesen Schichtaufbau innerhalb des piezokeramischen Vielschichtaktors entstehen Design bedingt piezoelektrisch inaktive Zonen. Da sich der piezokeramische Vielschichtaktor nur in piezoelektrischen aktiven Bereichen in seiner Länge ausdehnt oder zusammenzieht, da in diesen Bereichen die Innenelektroden unterschiedlicher Polarität direkt übereinander angeordnet sind, treten im Übergangsbereich zu piezoelektrisch inaktiven Zonen mechanische Spannungen innerhalb des Vielschichtaktors auf. Diese mechanischen Spannungen führten zu Rissbildung im Lagenaufbau des Vielschichtaktors, die den elektrischen Kontakt der Außenmetallisierung zu den einzelnen Elektroden beeinträchtigen oder sogar zum Totalausfall des Vielschichtaktors führen kann. Das Problem der Rissbildung wird durch den Einsatz vollaktiver piezoelektrischer Vielschichtaktoren reduziert. In diesen vollaktiven piezoelektrischen Vielschichtaktoren sind keine piezoelektrisch inaktiven bzw. passiven Bereiche vorhanden, weil sich die Innenelektroden beider elektrischer Potentiale über den gesamten Querschnitt des Vielschichtaktors allseitig bis zu dessen Rand erstrecken.

EP 1 206 804 B1 offenbart ein Herstellungsverfahren für piezoelektrische Vielschichtaktoren. Auf den einzelnen Mehrschichtstrukturen werden auf den Seitenflächen der Elektroden gleicher Polarität elektrochemisch elektrisch leitende Materialien abgeschieden. Diese Materialien bilden Stege aus, die nach dem Isolieren der zwischen diesen Stegen angeordneten Seitenflächen der Elektroden elektrisch miteinander verbunden werden.

DE 42 24 284 A1 offenbart die Herstellung eines Vielschicht-Riegels und dessen nachfolgende Sinterung als Vorstufe für die Herstellung von piezokeramischen Vielschichtaktoren. Ein derartiger Riegel weist beispielsweise die Tiefe senkrecht und die Länge parallel zu seiner Stapelrichtung gemäß einem späteren Vielschichtaktor auf. Seine Breite senkrecht zur Stapelrichtung ist ein Mehrfaches einer späteren Breite eines piezokeramischen Vielschichtaktors. Nach dem Sintern wird die Elektrodenstruktur der einzelnen piezokeramischen Vielschichtaktoren gemeinsam an dem Vielschicht-Riegel erzeugt und nachfolgend wird dieser in einzelne Vielschichtaktoren zerlegt. Zur Herstellung der Elektrodenstruktur wird an den Seitenflächen jeder zweiten Elektrode elektrochemisch leitendes Material abgeschieden. Die dazwischenliegenden Bereiche, d.h. Keramik und Elektrode, werden durch Ätzen oder mechanisches Abtragen in den gesinterten Vielschicht-Riegel zurückgesetzt. Diese Vorgänge sind aufwendig, da der gesinterte Vielschicht-Riegel widerstandsfähig gegenüber mechanischem und chemischem Angriff ist. Nachfolgend wird in den zurückgesetzten Bereichen eine Isolationsschicht aufgebracht und für jeden späteren Vielschichtaktor Außenelektroden erzeugt. Abschließend wird der gesinterte Vielschicht-Riegel in einzelne piezokeramische Vielschichtaktoren zerteilt.

US 5,568,679 und WO 2005/075113 A1 beschreiben ebenfalls das Erzeugen strukturierter Außenelektroden an einem bereits gesinterten Vielschicht-Vorkörper. An jeder Innenelektrode gleicher Polarität wird elektrochemisch ein elektrisch isolierendes Material abgeschieden, so dass die Seitenflächen dieser Elektroden nach außen isoliert sind. Nachfolgend wird auf die Außenseiten ein elektrisch leitendes Material aufgebracht, das die noch freiliegenden Seitenflächen der Elektroden der anderen Polarität miteinander verbindet. Abschließend wird der gesinterte Vielschicht-Riegel mit strukturierter Elektrode in einzelne piezokeramische Vielschichtaktoren zerteilt.

Aus der JP 01 184 968 A ist ein Verfahren zur Herstellung eines Grünriegels bekannt, wobei die Elektroden des Vielschicht-Riegels abwechselnd an gegenüberliegenden Stirnseiten des Vielschicht-Riegels beginnend sich über nicht die vollständige Breite des Vielschicht-Riegels erstrecken.

Aus der JP 05 267743 A ist das Aufbringen von Außenelektroden auf den noch nicht vereinzelten Vielschicht-Riegel bekannt.

Schließlich ist aus der DE 44 10504 A1 bekannt, dass Aussparungen, die durch elektrochemisches Zurücksetzen von Innenelektroden an einem gesinterten Vielschichtkörper gebildet werden, mit isolierendem Keramikmaterial gefüllt werden, das anschließend einer Wärmebehandlung unterzogen wird.

Es ist die Aufgabe der vorliegenden Erfindung, Herstellungsverfahren für einen piezokeramischen Vielschichtaktor bereitzustellen, die mit geringerem Aufwand und daher auch mit geringeren Kosten verglichen zum Stand der Technik durchführbar sind.

Die obigen Aufgaben werden durch das Herstellungsverfahren gemäß dem unabhängigen Patentansprüch 1 gelöst. Vorteilhafte Ausgestaltungen und Weiterentwicklungen der vorliegenden Erfindung gehen aus der folgenden Beschreibung, den Zeichnungen und den anhängenden Patentansprüchen hervor.

Das erfindungsgemäße Herstellungsverfahren weist die folgenden Schritte auf: Herstellen eines Vielschicht-Riegels als Grünkörper bestehend aus einer abwechselnden Anordnung einer Mehrzahl piezokeramischer Schichten und einer Mehrzahl von Elektroden in einer Stapelrichtung des Vielschicht-Riegels, während eine Tiefe des Vielschicht-Riegels senkrecht zur Stapelrichtung einer Tiefe eines vielschichtaktors und eine vollständige Breite des Vielschicht-Riegels senkrecht zur Stapelrichtung der Breite einer Mehrzahl von Vielschichtaktoren entspricht und sich die Elektroden über die gesamte Tiefe des Vielschicht-Riegels und abwechselnd an gegenüberliegenden Stirnseiten des Vielschicht-Riegels beginnend über nicht die vollständige Breite des Vielschicht-Riegels erstrecken, Anordnen von gegenüberliegenden Hilfselektroden an den um die Breite des Vielschicht-Riegels beabstandeten Stirnseiten, so dass mit den gegenüberliegenden Hilfselektroden um eine Elektrode in Stapelrichtung versetzt jeweils jede zweite Elektrode elektrisch ansteuerbar ist, elektrochemisches Zurücksetzen parallel zur Tiefe des Vielschicht-Riegels, insbesondere Ätzen, einer Seitenfläche jeder zweiten Elektrode, so dass an gegenüberliegenden Breitseiten des Vielschicht-Riegels jeweils jede zweite Seitenfläche der Elektrode in den Vielschicht-Riegel zurückgesetzt ist und die zurückgesetzten Seitenflächen der Elektroden an gegenüberliegenden Breitseiten des Vielschicht-Riegels in Stapelrichtung um eine piezokeramische Schicht voneinander beabstandet sind, Beschichten der zurückgesetzten Seitenflächen der Elektroden mit einer elektrisch isolierenden Schicht aus einem keramischen oder glasartigen Schlickerguss und Aufbringen jeweils einer Mehrzahl von Außenelektroden an den gegenüberliegenden Breitseiten des Vielschicht-Riegels parallel zur Stapelrichtung, Sintern und Trennen des Vielschicht-Riegels parallel zu dessen Tiefen- und Stapelrichtung in eine Mehrzahl piezokeramischer Vielschichtaktoren, wobei der Schlicker und der Vielschicht-Riegel zusammen ausgebrannt bzw. gesintert werden.

Um den Herstellungsaufwand von voll-aktiven piezoelektrischen Vielschichtaktoren zu reduzieren, wird der größte Teil der Herstellungsschritte an einem Vielschicht-Riegel im Grünzustand vorgenommen. Dieser Riegel ist aufgrund seines noch nicht gesinterten keramischen Gefüges mit geringerem Aufwand und daher mit geringeren Kosten bearbeitbar. Zudem bietet der Vielschicht-Riegel mit Hilfselektroden an seinen um die Breite beabstandeten Stirnseiten die Möglichkeit, gleichzeitig eine Mehrzahl von piezoelektrischen Vielschichtaktoren herzustellen, indem der Vielschicht-Riegel am Ende des Herstellungsverfahrens in einzelne Vielschichtaktoren getrennt wird.

Zur Herstellung strukturierter Elektroden an den Außenseiten des Vielschicht-Riegels werden zunächst die Seitenflächen jeder zweiten Elektrode durch Ätzen in den Vielschicht-Riegel zurückgesetzt bzw. hineinversetzt. Die sich ausbildenden Vertiefungen, in denen die Seitenflächen jeder zweiten Elektrode angeordnet sind, werden mit Schlicker eines nach dem Ausbrennen elektrisch isolierenden Materials gefüllt. Diese Materialien sind Glas oder Keramik. Basierend auf dem Ätzen und dem nachfolgenden elektrischen Isolieren durch Schlicker sind die Seitenflächen jeder zweiten elektrisch zu verbindenden Elektrode freiliegend außerhalb der Senken angeordnet, so dass sie beispielsweise durch Aufdrucken einer Au-βenmetallisierung elektrisch miteinander verbunden werden können.

Die vorliegende Erfindung wird unter Bezugnahme auf die begleitende Zeichnung näher beschrieben. Es zeigen:
- Figur 1A, B: verschiedene Ausführungsformen eines Vielschicht-Riegels,
- Figur 2: eine schematische Darstellung zur elektrochemischen Behandlung eines Vielschicht-Riegels,
- Figur 3: eine Ausschnittsvergrößerung des Vielschicht-Riegels nach einem nicht erfindungsgemäßen Schritt elektrochemischen Abscheidens (S3),
- Figur 4: einen Ausschnitt des Vielschicht-Riegels nach dem erfindungsgemäßen Prozess des Ätzens (S4),
- Figur 5: eine Ausschnittsvergrößerung des Vielschicht-Riegels zur Verdeutlichung des nicht erfindungsgemäßen Abtragens mittels Sägen, Schleifen und ähnlichen Verfahren (S5),
- Figur 6: eine Darstellung des Schnitts entlang der Linie A-A aus Fig. 5,
- Figur 7: eine Ausschnittsvergrößerung des Vielschicht-Riegels zum Verdeutlichten des Abtragens nicht parallel zur Seitenfläche der Elektroden,
- Figur 8: eine Schnittdarstellung entlang der Linie A-A aus Fig. 7,
- Figur 9: eine Schnittdarstellung entlang der Linie B-B aus Fig. 7,
- Figur 10: eine Schnittdarstellung entlang der Linie C-C aus Fig. 7, und
- Figur 11: ein Flussdiagramm zur schematischen Darstellung des Herstellungsverfahrens einschließlich zweier nicht erfindungsgemäßen Varianten S3 und S5.

Um den piezokeramischen Vielschichtaktor herzustellen, werden zunächst piezokeramische Grünfolien gegossen. Nachfolgend werden die Grünfolien mit Elektrodenmaterial bedruckt, das beispielsweise aus Silber-Palladium-Legierungen besteht. Diese Flächen bilden die späteren Innenelektroden 20. Des Weiteren werden die bedruckten Grünfolien in Stapelrichtung S übereinander zu einem Stapel angeordnet. Vorzugsweise ist zwischen zwei bedruckten Grünfolien eine unbedruckte Grünfolie angeordnet, um eine elektrische Kurzschlussgefahr im Inneren des späteren Vielschichtaktors zu reduzieren.

Nach dem Stapeln der Grünfolien liegen diese als Block vor, d.h. Breite und Tiefe des Blocks sind jeweils ein vielfaches der Tiefe und Breite eines späteren Vielschichtaktors. Im Grünzustand ist der Block ausreichend beständig, um chemisch, mechanisch oder auf andere Weise bearbeitet zu werden. Zudem ist das Gefüge des Blocks weniger widerstandsfähig als im gesinterten Zustand, so dass eine Bearbeitung des Blocks mit geringerem Aufwand durchführbar ist.

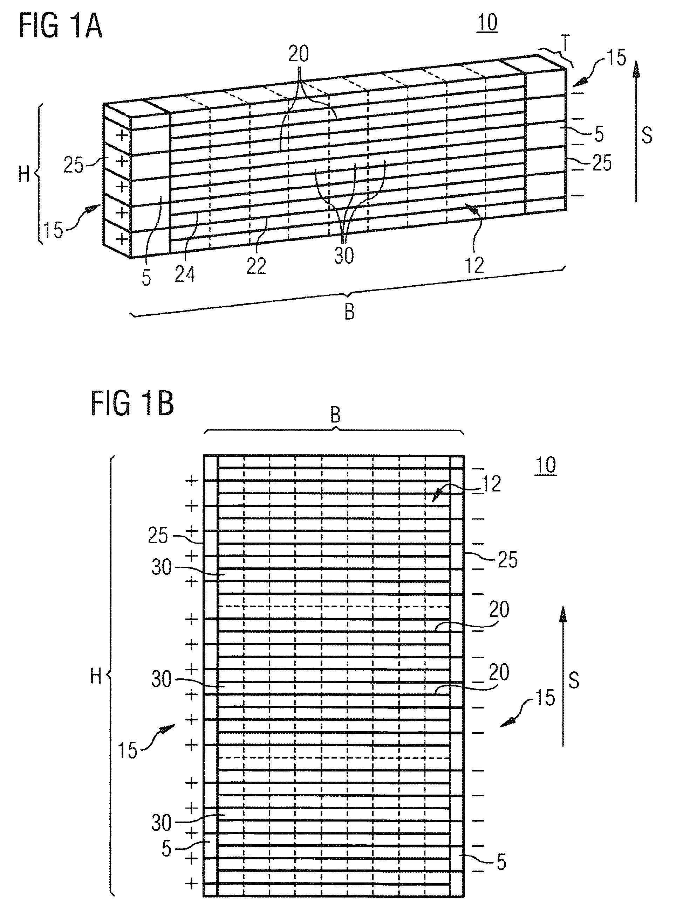

Der Block (nicht gezeigt) im Grünzustand wird in eine Mehrzahl von Vielschicht-Riegeln 10 zerteilt, beispielsweise durch Sägen. Der Vielschicht-Riegel 10 als Grünkörper umfasst eine abwechselnde Anordnung einer Mehrzahl piezokeramischer Schichten 30 und einer Mehrzahl von Elektroden 20 in Stapelrichtung S. Eine Tiefe T des Vielschicht-Riegels 10 senkrecht zu seiner Stapelrichtung S entspricht einer Tiefe eines Vielschichtaktors nach der Herstellung und eine roll ständige Breite B des Vielschicht-Riegels 10 senkrecht zu seiner Stapelrichtung S entspricht der Breite einer Mehrzahl von Vielschichtaktoren nach ihrer Herstellung (vgl. Fig. 1A, B). Die Elektroden 20 des Vielschicht-Riegels 10 erstrecken sich über die gesamte Tiefe T des Vielschicht-Riegels 10.

Gemäß einer Ausführungsform (vgl. Fig. 1A) entspricht die Höhe H des Vielschicht-Riegels 10 annähernd einer Höhe eines späteren Vielschichtaktors im gesinterten Zustand. Nach weiteren Bearbeitungsschritten und dem Sintern (s. unten) wird der Vielschicht-Riegel 10 durch Trennschnitte parallel zu seiner Stapelrichtung S in einzelne Vielschichtaktoren zerlegt (vgl. die gestrichelten Linien in Fig. 1A Gemäß einer weiteren Ausführungsform (vgl. Fig. 1B) wird der gesinterte Vielschicht-Riegel 10 durch Schnitte parallel und senkrecht zu seiner Stapelrichtung S entlang der gestrichelten Linien zerlegt. Mit Hilfe des Vielschicht-Riegels 10 im Grünzustand werden somit gleichzeitig mehrere vielschichtaktoren hergestellt, während zudem eine vereinfachte Bearbeitung im Grünzustand im Rahmen des Herstellungsverfahrens ausgenutzt wird.

Der Vielschicht-Riegel 10 im Grünzustand umfasst die bereits oben erwähnten, jeweils abwechselnd in Stapelrichtung S angeordneten piezokeramischen Schichten 30 und Elektroden 20. Die Seitenflächen 22, 24 der Elektroden 20 reichen jeweils bis an die Oberfläche der Breitseiten 12 des vielschicht-Riegels 10. Der Vielschicht-Riegel 10 umfasst an seinen gegenüberliegenden Stirnseiten 15 jeweils eine Hilfselektrode 25. Jede zweite Elektrode 20 beginnt an einer Hilfselektrode 25 und endet vor der gegenüberliegenden Hilfselektrode 25. Die Elektroden 20 erstrecken sich daher nicht über die gesamte Breite B des Vielschicht-Riegels 10. Jede zweite Elektrode 20 mit den Seitenflächen 22 oder 24 ist somit basierend auf der Nutzung der Hilfselektroden 25 gemeinsam elektrisch ansteuerbar. Aus dieser Konstruktion ergeben sich aber ebenfalls die piezoelektrisch inaktiven Bereiche 5 angrenzend an die Stirnseiten 15 des Vielschicht-Riegels 10. Diese sind für die Herstellung von Vielschichtaktoren als verlorene Bereiche anzusehen, da sie nach Abschluss des Herstellungsverfahrens keinen weiteren Nutzen haben.

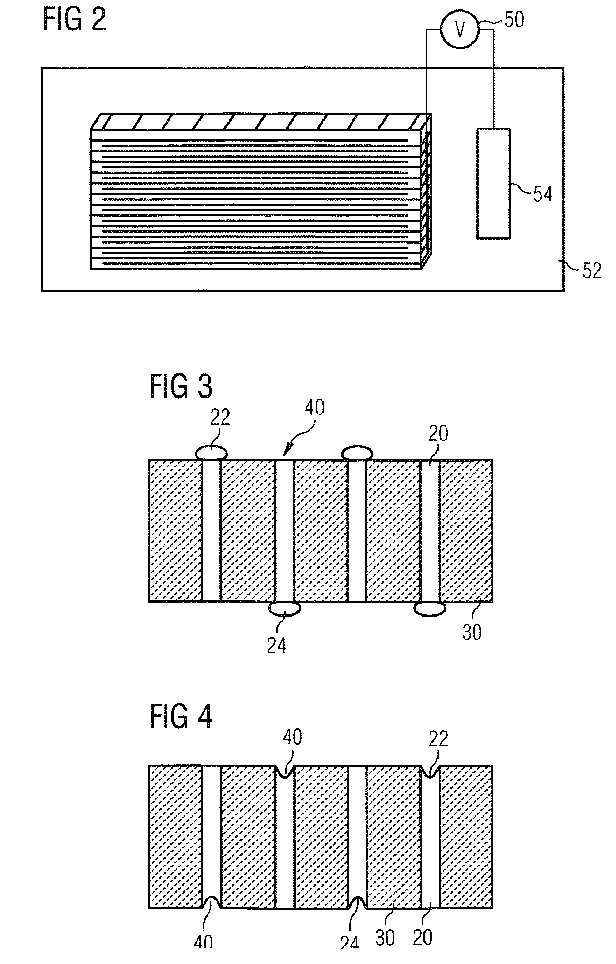

Nachdem der Vielschicht-Riegel 10 im Grünzustand vorliegt, d.h. die Schritte Herstellen des Vielschicht-Riegels S1 und Anordnen von Hilfselektroden S2 abgeschlossen sind, wird vorzugsweise eine Breitseite 12 mit einer Passivierungsschicht isoliert. Nach dem Aufbringen der Passivierungsschicht wird der Vielschicht-Riegel 10 in einem Elektrolyt-Bad elektrochemisch behandelt (vgl. Fig. 2). Es ist ebenfalls denkbar, den Vielschicht-Riegel ohne Passivierungsschicht zu bearbeiten. In diesem Fall wird nur eine Breitseite 12 des Vielschicht-Riegels in einen Elektrolyten 52 (vgl. Fig. 2) eingetaucht, um diese Breitseite elektrochemisch zu bearbeiten.

Gemäß der Erfindung wird eine Senken-Struktur durch elektrolytisches Ätzen S4 erzeugt. Zu diesem Zweck wird der Vielschicht-Riegel 10 nur mit einer Breitseite 12 oder vollständig mit einer zuvor passivierten Breitseite 12 in ein Ätzbad getaucht. Das Ätzbad umfasst bevorzugt übliche Elektrolytlösungen, wie bspw. wässrige Natriumchlorid-Lösung oder Natriumnitrat-Lösung. Danach wird über nur eine Hilfselektrode 25 eine elektrische Gleichspannung an die Elektrode 20 mit den Seitenflächen 22 angelegt. Daher werden nur die Seitenflächen 22 der Elektroden 20 elektrochemisch abgetragen. Danach wird die gegenüberliegende Breitseite 12 ins Ätzbad getaucht und die andere Hilfselektrode 25 elektrisch angesteuert. Dadurch werden die Seitenflächen 24 der Elektroden 20 abgetragen. Es ist ebenfalls denkbar, die gegenüberliegende Breitseite 12 mit einer Passivierungsschicht zu versehen und die andere Hilfselektrode 25 elektrisch anzusteuern. Mit Hilfe dieses Ätzverfahrens werden die Seitenflächen 24 weggeätzt bzw. zurückgesetzt. Es bildet sich an beiden Breitseiten 12 eine Mehrzahl von Senken 40 zwischen jeweils nicht geätzten Seitenflächen 22 oder 24 der Elektroden 20 aus. Da die Seitenflächen 22, 24 im Vergleich zu den piezokeramischen Seitenflächen der Schichten 30 kleiner sind, lassen sich diese mit weniger Aufwand ätzen und dadurch parallel zur Tiefenrichtung T in den Vielschicht-Riegel 10 zurücksetzen.

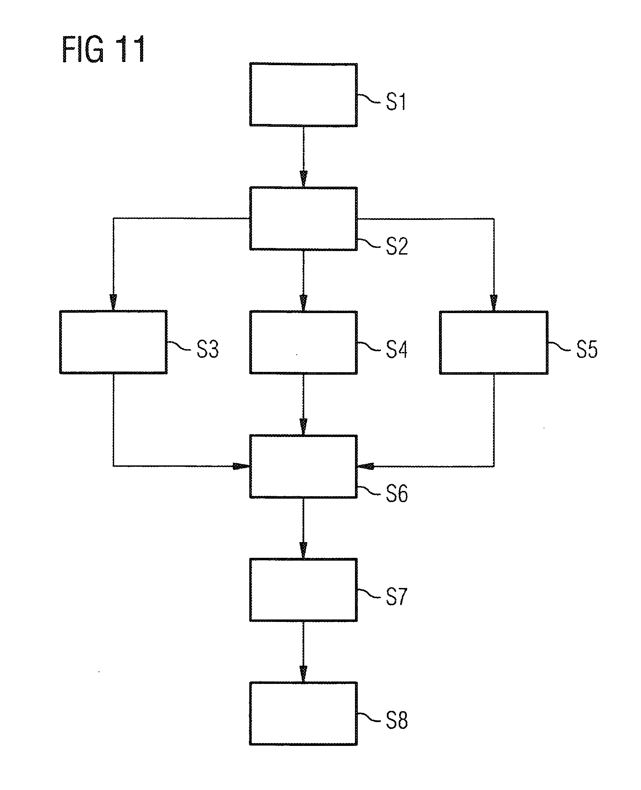

Um nun unabhängig von den vorangegangenen Herstellungsschritten jede zweite Elektrode 20 an den Breitseiten 12 elektrisch zu isolieren, so dass Außenmetallisierungen aufgedruckt werden können (Schritt S7 in Fig. 11), werden die Senken 40 mit einem Schlicker gefüllt. Der Schlicker füllt die Senken 40 (vgl. Figur 4) soweit, dass die jeweils in den Senken 40 angeordneten Elektroden 20 durch eine Schicht (nicht gezeigt) abgedeckt sind. Der Schlicker basiert auf einem keramischen oder glasartigen Pulver, so dass sich nach Trocknen des Schlickers eine elektrisch isolierende Schicht in den Senken 40 über den Elektroden 20 ausbildet. Während des Sinters S8 des Vielschicht-Riegels 10 wird der Schlicker in den Senken 40 ebenfalls verfestigt, so dass sich eine widerstandsfähige Schicht ohne eine gesonderte Wärmebehandlung ausgebildet.

Dann erfolgt das Aufbringen der Außenmetallisierungen und das Trennen des Vielschicht-Riegels in einzelne Vielschichtaktoren.

Vor dem Sintern S8 werden in den Bereichen, die nach dem Zerteilen des Vielschicht-Riegels 10 einzelne Vielschichtaktoren ergeben, Außenmetallisierungen aufgedruckt (S7). Das Aufdrucken der Außenmetallisierungen erfolgt beispielsweise mit Siebdruck oder anderen gängigen Verfahren. Anschließend wird der Vielschicht-Riegel 10 mit Außenmetallisierung gesintert und in einzelne Vielschichtaktoren entlang der gestrichelten Linien in den Figuren 1A, B vereinzelt. Im Zuge der Vereinzelung werden die inaktiven Bereiche 5 mit den angrenzenden Hilfselektroden 25 abgetrennt. Es ist bevorzugt, das Vereinzeln bzw. Trennen S7 vor oder nach dem Sintern S8 durchzuführen. Vereinzelt man beispielsweise vor dem Sintern S8, ist das Gefüge des Vielschicht-Riegels 10 weniger hart, so dass das Vereinzeln mit geringerem Aufwand durchführbar ist.

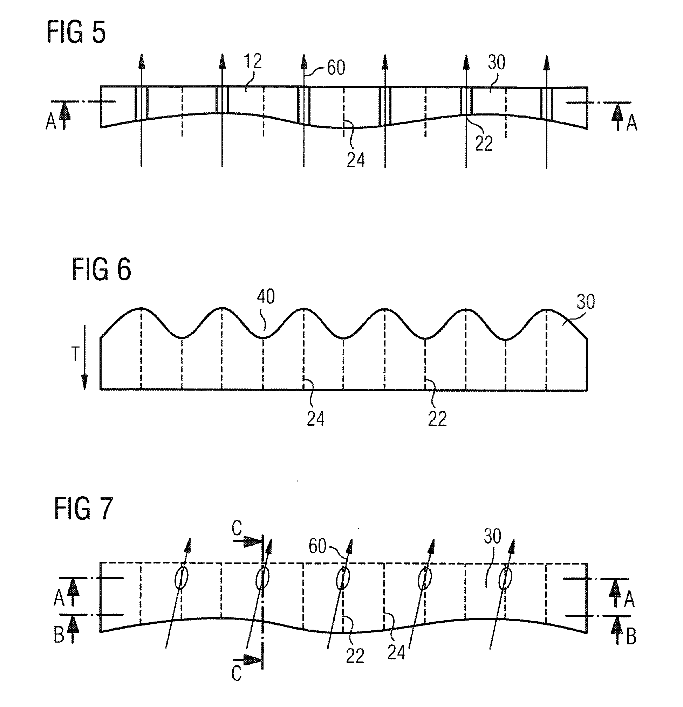

Gemäß einer nicht erfindungsgemäßen Herstellungsalternative kann die oben beschriebene Senken-Struktur durch Abtragen S5 der Seitenflächen 22; 24 der Elektroden 20 gemäß Fig. 5 bis 10 erzeugt werden. Die Herstellungsroute mit diesem Verfahrensschritt S5 benötigt weder einen Vielschicht-Riegel 10/Stack (siehe unten) mit Hilfselektroden 25 und piezoelektrisch inaktiven Bereichen 5 noch eine Passivierungsschicht. Daher ist hier eine vereinfachte Bearbeitung im Vergleich zu den vorhergehenden Verfahrensrouten an einer piezoelektrisch vollaktiven Schichtstruktur möglich.

In dem Vielschicht-Riegel 10 im Grünzustand, der in Fig. 5 in einem Ausschnitt gezeigt ist, werden an einer Breitseite 12 die Elektrodenflächen 22 abgetragen. Das Abtragen erfolgt mittels Schleifen, Sägen, Lasern, Erodieren und/oder Stoßen in Tiefenrichtung T des Vielschicht-Riegels 10. Gemäß einer ersten Alternative des Abtragens S5 werden an einer Breitseite 12 die Seitenflächen 22 jeder zweiten Elektrode 20 parallel zu ihrer Verlaufsrichtung abgetragen (vgl. Fig. 5, 6). Die Abtragsrichtung 60 ist parallel zur Seitenfläche 22 ausgerichtet. Aufgrund dieser Bearbeitung werden die Seitenflächen 22 in Tiefenrichtung T in den Vielschicht-Riegel 10 zurückgesetzt, so dass die Senken 40 entstehen. Zur Veranschaulichung zeigt Fig. 6 einen Schnitt entlang der Linie A-A aus Fig. 5.

Der obige Vorgang wird an beiden Breitseiten 12 des Vielschicht-Riegels 10 durchgeführt, um danach die Senken mit Schlicker zu isolieren, Außenmetallisierungen aufzubringen und das Sintern S8 durchzuführen (s. oben).

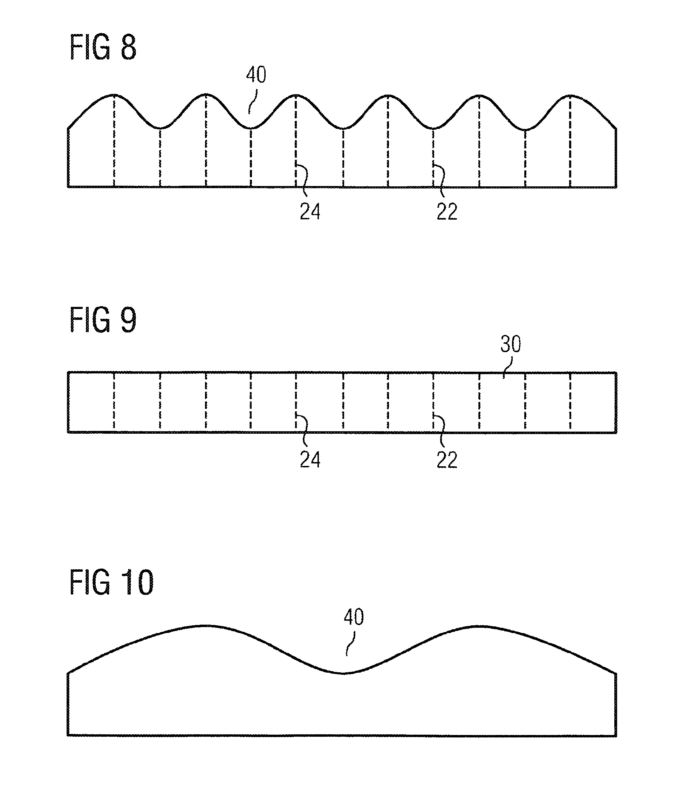

Gemäß einer weiteren nicht erfindungsgemäßen Alternative ist die Abtragsrichtung 60 nicht parallel zur Verlaufsrichtung der Seitenflächen 22; 24 der Elektroden 20 ausgerichtet (vgl. Fig. 7). Dies eröffnet die Möglichkeit, nur einen Teilbereich der Seitenflächen 22; 24 abzutragen, um den Herstellungsaufwand zu verringern. Betrachtet man den Schnitt entlang der Linie A-A in Fig. 7, ergibt sich auch durch das nicht parallele Abtragen wieder die Senken-Struktur (vgl. Fig. 8), wie sie oben bereits beschrieben worden ist. Die Senken 40 sind in diesem Fall räumlich auf einen Teilbereich der Seitenflächen 22; 24 begrenzt, wie aus den Schnitten entlang der Linie B-B und C-C in Fig. 7 hervorgeht (vgl. Fig. 9 und 10). Bei diesem schrägen Abtragen im Vergleich zur Verlaufsrichtung der Seitenflächen 22; 24 der Elektroden 20 wird man mit Sicherheit die Seitenflächen 22; 24 schneiden und in einem Teilbereich abtragen. Dies erfordert im Vergleich zum parallelen Abtragen einen geringeren Justageaufwand der Maschine zum Abtragen, um jeweils jede zweite Elektrode 20 in den Vielschicht-Riegel 10 zurückzusetzen und nachfolgend zu isolieren.

Nach Erzeugen der Senken-Struktur an beiden Breitseiten 12 des Vielschicht-Riegels 10 werden die gleichen Verfahrensschritte und Verfahrensalternativen durchgeführt, wie sie bereits oben beschrieben worden sind.

## Patentansprüche

1. Herstellungsverfahren für einen piezokeramischen Vielschichtaktor, das die folgenden Schritte aufweist:
a) Herstellen eines Vielschicht-Riegels (10) als Grünkörper bestehend aus einer abwechselnden Anordnung einer Mehrzahl piezokeramischer Schichten (30) und einer Mehrzahl von Elektroden (20) in einer Stapelrichtung (S) des Vielschicht-Riegels (10), während eine Tiefe (T) des Vielschicht-Riegels (10) senkrecht zur Stapelrichtung (S) einer Tiefe eines vielschichtaktors und eine vollständige Breite (B) des Vielschicht-Riegels (10) senkrecht zur stapelrichtung (S) der Breite (B) der Mehrzahl von Vielschichtaktoren entspricht und sich die Elektroden (20) über die gesamte Tiefe (T) des Vielschicht-Riegels (10) und abwechselnd an gegenüberliegenden Stirnseiten (15) des Vielschicht-Riegels (10) beginnend über nicht die vollständige Breite (B) des Vielschicht-Riegels (10) erstrecken,
b) Anordnen von gegenüberliegenden Hilfselektroden (25) an den um die Breite (B) des Vielschicht-Riegels (10) beabstandeten Stirnseiten (15), so dass mit den gegenüberliegenden Hilfselektroden (25) um eine Elektrode (20) in Stapelrichtung (S) versetzt jeweils jede zweite Elektrode (20) elektrisch ansteuerbar ist,
c) elektrochemisches Zurücksetzen parallel zur Tiefe (T) des Vielschicht-Riegels (10), insbesondere Ätzen, einer Seitenfläche (22; 24) jeder zweiten Elektrode (20), so dass an gegenüberliegenden Breitseiten (12) des Vielschicht-Riegels (10) jeweils jede zweite Seitenfläche (22; 24) der Elektroden (20) in den Vielschicht-Riegel (10) zurückgesetzt ist und die zurückgesetzten Seitenflächen (22; 24) der Elektroden (20) an gegenüberliegenden Breitseiten (12) das Vielschicht-Riegels (10) in Stapelrichtung (S) um eine piezokeramische Schicht (30) voneinander beabstandet sind,
d) Beschichten der zurückgesetzten Seitenflächen (22; 24) der Elektroden (20) mit einer elektrisch isolierenden Schicht und Aufbringen jeweils einer Mehrzahl von Außenelektroden an den gegenüberliegenden Breitseiten (12) des Vielschicht-Riegels (10) parallel zur Stapelrichtung (S),
e) Sintern und Trennen des Vielschicht-Riegels (10) parallel zu dessen Tiefen(T)- und Stapelrichtung (S) in eine Mehrzahl piezokeramischer Vielschichtaktoren,
wobei
die zurückgesetzten Seitenflächen (22; 24) der Elektroden (20) jeweils in einer Senke (40) angeordnet sind, die zum Beschichten mit der elektrisch isolierenden Schicht aus einem keramischen oder glasartigen Schlickerguss gefüllt und ausgebrannt werden,
wobei das Ausbrennen des Schlickers zusammen mit dem Sintern des Vielschicht-Riegels erfolgt.

2. Herstellungsverfahren gemäß Anspruch 1, in dem die Mehrzahl von Außenelektroden an den gegenüberliegenden Breitseiten (12) des Vielschicht-Riegels (10) aufgedruckt werden.

3. Herstellungsverfahren gemäß einem der vorhergehenden Ansprüche, in dem die Stirnseiten (15) mit den Hilfselektroden (25) derart abgetrennt werden, dass keine piezoelektrisch inaktiven Bereiche (5) im Vielschicht-Riegel (10) zurückbleiben.

## Claims

1. Production method for a piezoceramic multilayer actuator, said method comprising the following steps of:
a) producing a multilayer bar (10) as a green body consisting of an alternating arrangement of a plurality of piezoceramic layers (30) and a plurality of electrodes (20) in a stacking direction (S) of the multilayer bar (10), while a depth (T) of the multilayer bar (10) normal to the stacking direction (S) corresponds to a depth of a multilayer actuator and a full width (B) of the multilayer bar (10) normal to the stacking direction (S) corresponds to the width (B) of the plurality of multilayer actuators and the electrodes (20) extend over the entire depth (T) of the multilayer bar (10) and in alternation starting at opposite front faces (15) of the multilayer bar (10) over not the full width (B) of the multilayer bar (10),
b) arranging opposite auxiliary electrodes (25) on the front faces (15) spaced apart around the width (B) of the multilayer bar (10) such that every second electrode (20) can be electrically driven in each case with the opposite auxiliary electrodes (25) offset by one electrode (20) in the stacking direction (S),
c) electrochemically setting back parallel to the depth (T) of the multilayer bar (10), in particular etching, a lateral surface (22; 24) of every second electrode (20) such that on opposite wide sides (12) of the multilayer bar (10) every second lateral surface (22; 24) of the electrodes (20) in each case is set back into the multilayer bar (10) and the set-back lateral surfaces (22; 24) of the electrodes (20) are spaced apart from one another by one piezoceramic layer (30) on opposite wide sides (12) of the multilayer bar (10) in the stacking direction (S),
d) coating the set-back lateral surfaces (22; 24) of the electrodes (20) with an electrically insulating layer and applying in each case a plurality of external electrodes on the opposite wide sides (12) of the multilayer bar (10) parallel to the stacking direction (S),
e) sintering and separating the multilayer bar (10) parallel to its depth (T) and stacking direction (S) into a plurality of piezoceramic multilayer actuators,
wherein
the set-back lateral surfaces (22; 24) of the electrodes (20) are in each case arranged in a recess (40), the recesses being filled and burned out for coating with the electrically insulating layer made of a ceramic or vitreous slip casting,
wherein the slip is burned out in combination with the sintering of the multilayer bar.

2. Production method according to claim 1, wherein the plurality of external electrodes are imprinted on the opposite wide sides (12) of the multilayer bar (10).

3. Production method according to one of the preceding claims, wherein the front faces (15) with the auxiliary electrodes (25) are split off in such a way that no piezoelectrically inactive zones (5) remain in the multilayer bar (10).

## Revendications

1. Procédé de fabrication pour un actionneur multicouche piézocéramique, comprenant les étapes suivantes :
a) fabrication d'une barre multicouche (10) comme corps de base formé d'un agencement alterné d'une pluralité de couches piézocéramiques (30) et d'une pluralité d'électrodes (20) dans une direction d'empilement (S) de la barre multicouche (10), tandis qu'une profondeur (T) de la barre multicouche (10) perpendiculairement à la direction d'empilement (S) correspond à une profondeur d'un actionneur multicouche et qu'une largeur totale (B) de la barre multicouche (10) perpendiculairement à la direction d'empilement (S) correspond à la largeur (B) de la pluralité d'actionneurs multicouches, et que les électrodes (20) s'étendent sur toute la profondeur (T) de la barre multicouche (10) et, en commençant en alternance sur des côtés frontaux opposés (15) de la barre multicouche (10), ne s'étendent pas sur toute la largeur (B) de la barre multicouche (10),
b) disposition d'électrodes auxiliaires opposées (25) sur les côtés frontaux (15) espacés de la largeur (B) de la barre multicouche (10), de manière à ce qu'une électrode (20) sur deux puisse à chaque fois être excitée électriquement, en sautant une électrode (20) dans la direction d'empilement (S), avec les électrodes auxiliaires opposées (25),
c) production d'un retrait par voie électrochimique parallèlement à la profondeur (T) de la barre multicouche (10), notamment gravure, d'une face latérale (22 ; 24) d'une électrode (20) sur deux, de manière à ce qu'une face latérale (22 ; 24) d'une électrode (20) sur deux dans la barre multicouche (10) présente un retrait sur des côtés larges opposés (12) de la barre multicouche (10) et à ce que les faces latérales en retrait (22 ; 24) des électrodes (20) soient séparées les unes des autres par une couche piézocéramique (30) sur des côtés larges opposés (12) de la barre multicouche (10) dans la direction d'empilement (S),
d) couverture des faces latérales en retrait (22 ; 24) des électrodes (20) avec une couche électriquement isolante et application, à chaque fois, d'une pluralité d'électrodes extérieures sur les côtés larges opposés (12) de la barre multicouche (10) parallèlement à la direction d'empilement (S),
e) frittage et séparation de la barre multicouche (10) parallèlement à sa profondeur (T) et à la direction d'empilement (S) en une pluralité d'actionneurs piézocéramiques,
les faces latérales en retrait (22 ; 24) des électrodes (20) étant situées à chaque fois dans une dépression (40) qui, pour la couverture avec la couche électriquement isolante, est remplie par coulage de barbotine céramique ou de type verre et soumise à une pyrogénation,
la pyrogénation de la barbotine ayant lieu en même temps que le frittage de la barre multicouche.

2. Procédé de fabrication selon la revendication 1, dans lequel la pluralité d'électrodes extérieures sont imprimées sur les côtés larges opposés (12) de la barre multicouche (10).

3. Procédé de fabrication selon l'une des revendications précédentes, dans lequel les côtés frontaux (15) avec les électrodes auxiliaires (25) sont séparés de manière à ce qu'il ne subsiste aucune zone piézoélectriquement inactive (5) dans la barre multicouche (10).
